# EUROPEAN PATENT APPLICATION

(11) **EP 4 821 610 A1**
(43) Date of publication of application: **14.10.2026**
(21) Application number: 26170871.3
(22) Date of filing: 07.04.2026
(51) Int. Cl.: B09B 3/30, B09B 3/35, B09B 5/00, H05K 3/22, C22B 7/00, C22B 11/02, B03B 9/06, B09B 101/15, B29B 17/02, B09B 101/17, B29B 17/04, B29B 17/00

(54) **AUTOMATED PLATFORM FOR THE RECOVERY OF ELECTRONIC COMPONENTS AND RAW MATERIALS FROM PCB BOARDS, AND RELATED PROCESS**

(30) Priority: 09.04.2025 IT 202500007812
(71) Applicant: Greenvincible Srl, 88100 Catanzaro (CZ) (IT)
(72) Inventor: DE GAETANO, DIEGO, 88040 SETTINGIANO (CZ) (IT)
(74) Representative: STUDIO RUBINO SRL

(57) **Abstract**

An automated platform for recovering electronic components and raw materials from PCB boards, comprising:
- a plurality of operating stations (101, 102, ..., 109) comprising at least: a first station (101) for automatic loading and cataloguing of at least one PCB board onto a conveyor belt; a second station (102) for storing said PCB board in at least one rack module (102a); a third station (103) for disassembling electronic components; a fourth station (104) for analysing and separating the electronic components disassembled; a fifth station (105) for cleaning said reusable disassembled electronic components; a sixth station (106) for granulation; a seventh station (107) for pulverizing fragments produced by the sixth station (106); an eighth station (108) for separation of raw materials; and a ninth station (109) configured for recovering plastic material; and
- a computer program product configured to manage said operating stations (101, 102, ..., 109).

## Description

The present invention relates to an automated platform for recovering electronic components and raw materials from PCB boards.

The present invention also relates to a process for recovering electronic components and raw materials from PCB boards.

In particular, the present invention aims to achieve high recovery rates both of recovered and reusable electronic components and of recycled and recovered raw materials obtained through sequential processing operations performed on end-of-life PCB boards.

As is known, proper management and disposal of electrical and electronic waste, or WEEE, is a matter of concern for researchers and environmental operators not only because of the large volumes of such waste generated, but also due to the presence therein of heavy metals and hazardous substances. If WEEE is not adequately treated and disposed of, it may cause contamination of soil and groundwater, with consequent risks to human health.

High concentrations of organic contaminants, including polybrominated diphenyl ethers and other carcinogenic agents, can be found in soils at WEEE disposal sites. Likewise, high concentrations of heavy metals such as cadmium, lead, copper, and zinc are observed in river sediment samples, due to material recovery performed using inappropriate techniques such as openair burning.

However, WEEE represents not only an environmental problem but also a valuable resource, since it contains critical and strategic materials such as rare earth elements, cobalt, nickel, palladium, and lithium, which are essential for multiple industrial sectors, from renewable energy to electric mobility. The acceleration of the energy transition and the increasing need for sustainable technologies, such as photovoltaic plants, wind turbines, and batteries for electric vehicles, have led to an unprecedented rise in demand for these materials. It is estimated, for example, that battery manufacturing capacity in the EU could increase from 44 GWh in 2020 to 1200 GWh by 2030, requiring enormous amounts of lithium, cobalt, and nickel. Moreover, new green technologies require up to six times more critical minerals than traditional technologies, further exacerbating Europe's dependence on imports.

Despite this growing need, the recovery of critical materials from WEEE remains highly limited. In 2022, on a global scale, 62 million tonnes of electronic waste were generated, but only 22.3% was properly collected and recycled. In Italy, the collection rate stands at 37%, well below the European target of 65%. This means that millions of tonnes of strategic raw materials end up in landfills or are treated through inefficient processes, making their recovery and reuse impossible.

To address this critical issue, the European Union launched in 2023 an ambitious plan for the recovery of critical raw materials, culminating in the adoption of Regulation (EU) 2024/1252, which imposes new obligations to improve the collection and treatment of WEEE and to reduce dependence on third countries. In line with this strategy, Italy implemented the framework through Decree-Law No. 84 of 25 June 2024, introducing measures to incentivize the recovery and reuse of strategic raw materials through innovative technologies.

The electrical and electronics industry is among the most innovative in terms of finished products, and this is reflected in the speed at which electronic devices, such as mobile phones and personal computers, become obsolete, generating large quantities of waste that must be handled appropriately.

In this technical field, a PCB electronic board, or Printed Circuit Board, is a hardware component defined by a printed circuit and mounted on a typical substrate, usually made of fiberglass-reinforced epoxy laminate (FR-4) or phenolic laminate (bakelite), complete with all the electrical and electronic components required to enable, through its own processing and control functions, the operation of a wide variety of manufactured items and equipment of varying complexity, across a broad range of technological sectors.

Electronic boards differ in type, size, and specific components depending on the equipment in which they are installed and the functions they must perform, as well as on the historical period in which they are manufactured.

A typical example of a PCB board is the motherboard of a personal computer, which is a type of electronic board configured as an extremely complex circuit, made from a multilayer stack, or layers, comprising approximately 33% ceramic and glass, namely fiberglass laminate, and a copper content that may range from about one gram per square centimeter in two-layer boards up to 12-16 grams per square centimetre for boards intended for more advanced devices such as modern smartphones, as well as gold, nickel, and tin-lead in variable quantities from 1% to 3% used to plate and protect specific portions of the board.

On PCB boards, a series of discrete components, integrated circuits (i.e., microchips), sockets, and various types of connectors, made up of multiple materials and metals, are soldered in place. Given the short life cycles of PCBs, compared to their potential operating life, it is intuitive to consider that, at the time of end-of-life, many components could be reused. In addition to the possibility of extracting raw materials from components, whether functional or not, it would also be possible to reintroduce some of them into industrial cycles, a possibility that exists only if the electronic board is well preserved. Whether one opts for recycling rather than reusing electronic components, the choice depends directly on the PCB board recycling processes, a practice that, at present, remains a particularly arduous task.

Thus, in view of the costs to be borne both economically and environmentally, it is often preferred to dispose of boards and the components mounted thereon in landfill, despite the fact that each of them constitutes an excellent reserve of raw materials.

Due to its complexity, however, the recycling of PCB boards is a very demanding task that has not yet been solved from the standpoint of systems technology and economic sustainability. As a result, at present, recycling processes refer only to the recovery of conventional metals in percentages of about 30-35%, while many precious metals such as beryllium, palladium, and cobalt, as well as the non-metallic fraction, are not recovered and are disposed of in landfill.

The metal recovery processes and the most widely used pre-treatment processes include electrolytic processes, smelting, and mechanical separation. The processes used to recycle PCBs can be divided into two categories depending on the type of material recovered and the process used, namely thermal processes with pyrometallurgical recovery, and non-thermal processes, i.e., electro-/hydrometallurgical processes. Both methodologies are highly energy-intensive and, by releasing dioxins and fumes into the atmosphere, producing sludges and acidic wastewater, require substantial investments for environmental protection purposes.

For these reasons, a significant percentage of WEEE is shipped and treated in developing countries, where environmental protection regulations are less stringent, or in Central and Northern European countries with a substantial presence of heavy industries capable of using WEEE for energy production purposes.

In general, the main cause of key-metal losses in the recycling process of electronic boards is the low efficiency of mechanical pre-treatment stages, whereas only marginal losses are due to subsequent collection and final extraction stages. Currently, the mechanical pre-treatment of electronic waste relies on manual dismantling processes to isolate hazardous components and to easily disassemble parts, and on mechanical crushing and separation processes aimed at reducing particle size and refining the input material into purified material streams that can be sold either on the raw-materials market or to companies performing further refining steps.

Despite the high variability of post-use products and the materials to be processed, the mechanical recycling systems currently available are rather rigid and cannot be adapted to different types of WEEE generated over time, depending on the technological life cycle of the products.

Several platforms and methodologies conceived for the recovery of raw materials from PCB boards are known from the patent literature.

For example, patent application EP1484119A1 describes a method and an apparatus for recycling printed circuit boards, suitable for separating and recovering metallic materials and insulating materials, both present in the boards. Both the metallic material and the insulating material, once separated and recovered, can be recycled. In the recycling method, hot filtration equipment and resin-metal separation equipment are used in a hot filtration process P400. The waste printed circuit board is heated and force-filtered so that only the insulating material passes through the filter. Subsequently, the insulating material and the metallic material are separated and recovered.

Patent document 102019000001089 instead relates to a process for the hydrometallurgical recovery of materials from electronic components of waste electrical and electronic equipment. The process allows the wet treatment of mixed material in powder form, derived from selective preparation and mechanical pre-treatment processes, at ambient temperature and with complete recovery of reagents at the end of each process cycle.

Finally, patent document 102021000026870, in the name of the same Applicant, relates to a plant and a method for recycling the materials present on PCB electronic boards, comprising steps of preliminary mapping of the boards, disassembling electronic components from the boards by means of Vapor Phase technique, crushing the bare boards by means of an opposed-jaw mill, hyperspectral analysis of the fragments obtained from the jaw mill, pulverizing the fragments by means of an orbital micronizer, separating the materials by means of a hybrid technique, and recovering the plastic material by means of electrostatic separation.

These and other systems known from the state of the art suffer from certain limitations, including reduced analysis capabilities, with particular reference to the absence of selflearning processing modules and hardware automation modules, with a view to increasing the yield of recovered materials and assessing the residual functionality and mechanical integrity of electronic components, also in relation to the different types of WEEE generated as a result of technological evolution.

The object of the present invention is to provide an automated platform equipped with advanced analysis functionalities that make it possible both to maximize the yield of raw-material recovery and to assess the residual functionality and mechanical integrity of electronic components suitable for reuse, thus having characteristics capable of overcoming the limitations that still affect the above-mentioned systems known from the prior art.

Furthermore, a further object of the present invention is to provide an automated platform for recovering electronic components and raw materials from PCB boards that implements the related process while minimizing environmental impact.

According to the present invention, an automated platform for recovering electronic components and raw materials from PCB boards is provided, as defined in claim 1.

According to the present invention, a process for recovering electronic components and raw materials from PCB boards is also provided, as defined in claim 15.

For a better understanding of the present invention, a preferred embodiment is now described, purely by way of nonlimiting example, with reference to the accompanying drawings, in which:
- Figure 1 shows a schematic representation of the operating stations comprised in the automated platform for recovering electronic components and raw materials from PCB boards, and of the steps of a corresponding process implemented by the automated platform, according to the invention;
- Figure 2 shows a first stage/operating station of the automated platform for recovering electronic components and raw materials from PCB boards, according to the invention;

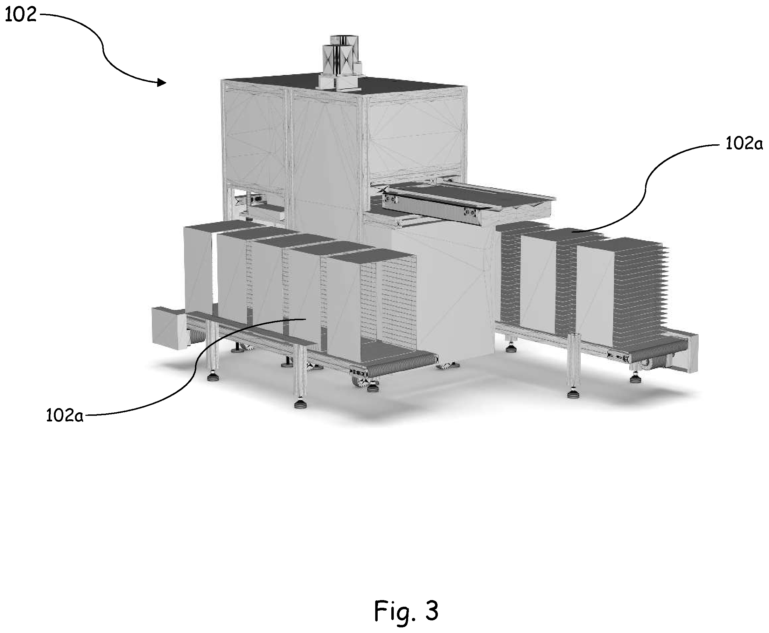

- Figure 3 shows a second operating station of the automated platform for recovering electronic components and raw materials from PCB boards, according to the invention;

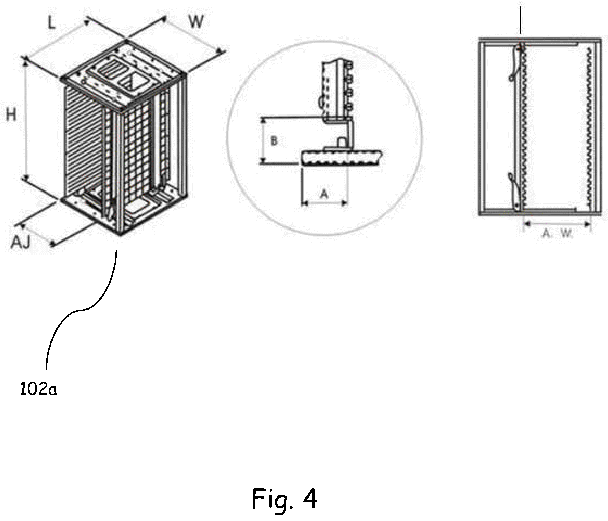

- Figure 4 shows a component comprised in the second operating station of the automated platform for recovering electronic components and raw materials from PCB boards, according to the invention;
- Figure 5 shows a third operating station of the automated platform for recovering electronic components and raw materials from PCB boards, according to the invention;
- Figure 6 shows a fourth operating station of the automated platform for recovering electronic components and raw materials from PCB boards, according to the invention;
- Figure 7 shows a fifth operating station of the automated platform for recovering electronic components and raw materials from PCB boards, according to the invention;

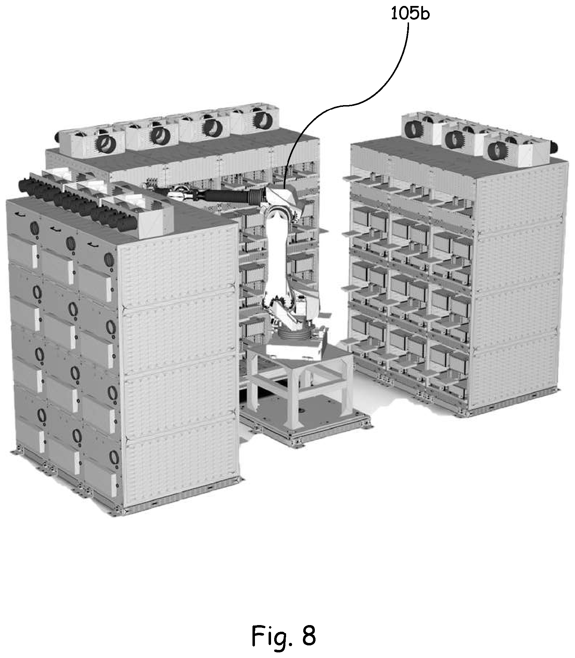

- Figure 8 shows a storage block for reusable electronic components, selected by means of the automated platform for recovering electronic components and raw materials from PCB boards, according to the invention;
- Figure 9 shows a sixth operating station of the automated platform for recovering electronic components and raw materials from PCB boards, according to the invention;
- Figure 10 shows a seventh operating station of the automated platform for recovering electronic components and raw materials from PCB boards, according to the invention;
- Figure 11 shows an eighth operating station of the automated platform for recovering electronic components and raw materials from PCB boards, according to the invention;
- Figures 12a, 12b show, respectively, a first and a second part of an exemplary table listing some raw materials that can be recovered by means of the automated platform for recovering electronic components and raw materials from PCB boards, according to the invention;
- Figure 13, finally, shows a ninth operating station of the automated platform for recovering electronic components and raw materials from PCB boards, according to the invention.

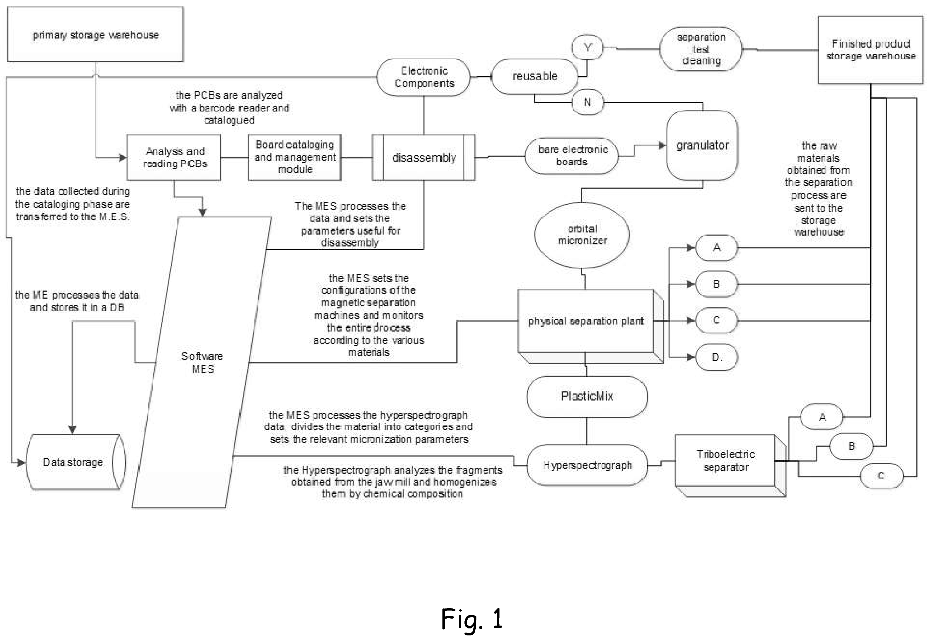

With reference to said figures, and in particular to Figure 1, an automated platform for recovering electronic components and raw materials from PCB boards is shown, according to the invention.

In particular, the automated platform for recovering electronic components and raw materials from PCB boards comprises:
- a plurality of operating stations, comprising at least: a first station 101 for automatic loading and cataloguing of at least one PCB board; a second station 102 for storing the PCB boards in corresponding rack modules 102a; a third station 103 for disassembling electronic components from the PCB boards; a fourth station 104 for analysing and separating the electronic components disassembled from the PCB boards, configured to identify and separate reusable disassembled electronic components; a fifth station 105 for cleaning said disassembled electronic components deemed reusable; a sixth station 106 for granulation adapted to crush both the PCB boards deprived of the disassembled electronic components, and thus "bare", and the disassembled electronic components separated at the fourth station 104 but deemed not reusable; a seventh station 107 comprising an orbital micronizer; an eighth station 108 for hybrid separation of raw materials fed from said seventh station 107; and a ninth station 109 configured for recovering plastic material;
- a computer program product configured to manage said plurality of operating stations.

According to one aspect of the invention, in particular, the configuration of said computer program product, i.e., a dedicated software application having a distributed architecture according to software modules installed, all or in part, on the individual operating stations of the automated platform, and optionally also on dedicated servers, can be framed as a control system for the entire platform, referred to as SYNAPSE (SYNchronized Advanced Processing & Scalable Engine), and represents a key factor in the design and management thereof. In fact, as will be apparent from what is described below, the amount of information handled and the need, determined by the plurality of materials to be processed, to ensure flexibility and reconfigurability of the sub-processes underlying the individual operating stations, qualify the relevance of such an IT/automation layer within the context of the overall platform.

Flexibility in the control infrastructure, to support the recovery and recycling objectives, is pursued at the level of each individual station/operating unit in order to exploit a set of automation functions and tasks that each machine, each device, and each software module, resident locally and executed by a corresponding electronic control unit ,preferably a PLC, a microcontroller, or a dedicated microprocessor for each station of the automated platform ,can perform.

In this regard, according to one aspect of the invention, the computer program product/control system is based on proprietary algorithms within an MPC solution, Model Predictive Control, capable of imparting the desired functional behaviour to the automated platform and of providing a framework that supports real-time data exchange among the various stations/equipment.

Model Predictive Control (MPC), in fact, performs optimal control with respect to the mathematical model of the controlled system, predicting its dynamics over a prediction horizon that defines the interval within which the MPC optimizes the system response parameters in order to obtain the best control strategy in a predictive manner, as opposed to the reactive approach used by PID methods and on/off control, thereby minimizing the control error.

This infrastructure, based on a set of PLCs, at least one for each of the above-mentioned operating stations of the automated platform, represents the physical and logical foundations enabling the coordinated operation of all modules distributed across the machines. The PLCs, in fact, communicate, cooperate, and negotiate in order to achieve common production objectives, which in the present case are aimed at recovering reusable electronic components and at recycling the disassembled PCB boards and non-functional electronic components, with consequent recovery of raw materials.

The basic services of the platform are developed as embedded elements on the individual stations and can be activated either directly via request-response messaging, or indirectly when included within other, higher-level complex services.

The introduced approach decomposes complex operational activities down to an elementary level, with each basic activity implemented as an atomic service intended to be combined with others into aggregates in order to obtain more complex functionalities. The set of basic services is then coordinated centrally by a central management software, referred to as a Manufacturing Execution System (MES), in turn comprised within the control system of the entire automated platform, i.e., the MPC logical architecture.

According to another aspect of the invention, the central management software, or MES control module, is connected at the software level to each PLC operating on a corresponding operating station.

The proprietary IT infrastructure is applied to manage, in an integrated and efficient manner, the entire recycling and recovery process, leveraging a backbone that directly interconnects the individual stations of the platform within the corresponding process/method.

In this regard, the algorithms of the proposed automated platform are designed so as to ensure interactive management of control sub-modules and to allow the individual operating stations used in the recycling and recovery process to evolve from stand-alone components managed in a rigid, hierarchical manner into autonomous, interacting, and cooperating components.

The control system is conceived to detect and interpret the characteristics of the production environment and to adapt according to specific needs, automatically achieving objectives at the level of each piece of equipment and globally at the level of process or sub-process. In this perspective, the system exhibits adaptive behavior deriving from an advanced reconfiguration mechanism, thanks to a form of intelligence that enables recognition of other entities operating in the process, of products, and of events.

The MPC logic dynamically builds the data structure required to handle the management of a specific plant according to the following flow: analysis of the optimization problem, acquisition of the state of the system to be controlled, solution of the optimization problem, and application of the calculated control action.

The control system, i.e., the management computer program product compliant with MPC predictive logic, is designed as a complex architecture based on a set of cooperating software modules, as said distributed, in whole or in part, on each operating station of the automated platform and, in particular, comprising at least:
- said central management software, or Manufacturing Execution System (MES), configurable as a control software module, conceived to detect and interpret the characteristics of the production environment, here, recovery and recycling, and to adapt its capabilities according to specific requirements. The module is divided into two levels, namely an upper first level and a lower second level. The upper level is tasked with controlling and coordinating the entire automated platform, ensuring compliance with operational and production constraints, supporting their assessment, implementation, and the related control functionalities. Such software layer implements plantlevel coordination functions. The lower level manages the set of PLCs and the related software module on the individual operating station, together with the various hardware devices employed in the production process, here, recycling and recovery, in order to control the operations of the individual equipment taking into account overall constraints and possible reciprocal dynamic influences. The modularization concept enables organization of the control solution into software entities encapsulated within standard interfaces, directly connected to the functional components of the system to be controlled, while improving application reusability;
- a communication module that manages the exchange of information and signals among the individual operating stations, in particular among the individual PLCs, and the central MES management software which, through deep-learning modules, collects data coming from peripheral software modules, analyses it, and generates second-level instructions that it sends to the individual devices and machines installed at the operating stations. Communication among the various modules, and the central control infrastructure, as well as with the environment of the individual device, takes place in real time through communication protocols capable of interpreting the individual languages in a continuous-learning environment. The selection of the communication protocols is made in order to improve system responsiveness while ensuring, at the same time, separation of the traffic, thereby avoiding interference between information flows having different requirements and timing;

- a performance management module whose function is to monitor the performance of the individual stations/processes 101, 102, ..., 109 by comparing them with the nominal capacities of the automated platform, and to correct in real time any behaviors in order to improve their execution or to make them more suitable for carrying out the process as a whole;
- a software module based on machine learning that determines the local and global optimization strategies that drive the central MES management software, or control software module, together with logic enabling the latter to learn and improve its functionalities over time;
- an analysis and classification module, based on deep-learning vision, capable of reading, inspecting, conceptualizing and generalizing the appearance of each electronic component disassembled from a PCB board on the basis of its distinctive features, even when these vary or deviate minimally, detecting the presence of non-conformities or defects. The module is thus capable of learning and recognizing the characteristics of each electronic component and proceeding with classification within a specific data repository;
- a simulation module which, building upon the preceding analysis stages, once the electronic components suitable for reuse in an industrial system have been identified, separating them from those to be recycled, simulates the sequence of disassembly techniques and the achievable results in terms of quality, quantity and value, identifying the most high-performing
alternative and sending the information to the central management software, or MES control software module. The cooperation and interaction mechanisms among the various modules are based on both physical and logical interfaces and ensure the possibility of operating in multiple configurations by using a shared "language", as well as common semantics and rules, thereby enabling interrelationships among devices and their functionalities. The internal data architecture is dynamic, with the possibility of dynamically building the data structure required to address control of the automated platform.

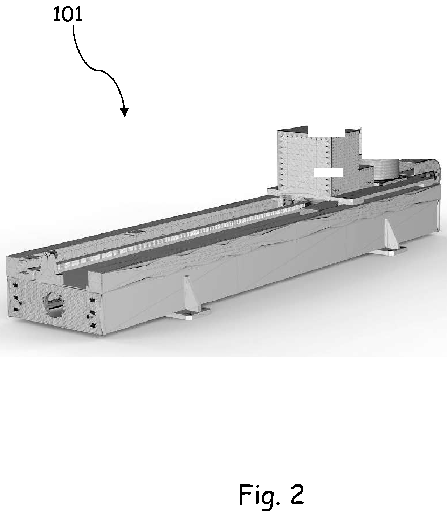

According to one aspect of the invention, the first operating stage of PCB processing, at the corresponding first loading and cataloguing station 101, schematically shown in Figure 2, provides that the PCB boards are automatically transferred from bins to the feeding system, minimizing the risk of component damage, by using a tilting movable bottom. This system allows gradual release of the boards without the use of potentially harmful vibrations. The controlled inclination of the movable bottom, managed by a pneumatic cylinder or an electric actuator, allows the PCB boards to slide gently towards the outlet without suffering impacts or shocks.

Once discharged from the bins, the PCB boards are placed on a low-speed conveyor belt lined with a cushioning and antistatic material to ensure smooth and safe transport. Along the path, a system of adjustable guides allows the boards to be aligned without exerting direct mechanical forces, preventing overlaps or accumulations. The flow of boards proceeds towards an inclined feed chute having a low-friction surface, which reduces friction and facilitates controlled advancement of the boards towards the pass-through regulation system. To further optimize flow management, an optical sensor can be integrated to monitor board passage and prevent any jams. Such a solution, preferred but not exclusive, offers several advantages, including gentle and controlled motion, elimination of vibrations, protection of electronic components through cushioning and antistatic materials, and a continuous and orderly flow without the need for human intervention.

To improve the recovery process of raw materials and electronic components and to ensure a higher level of environmental protection, preliminary characterization of the PCB boards to be processed is carried out, in order to better understand the treatment to be used. As the PCB boards move from the dismantling phase to the separation of components and raw materials, the value of the recovered materials is optimized through accurate classification. Data on the composition of the boards must be monitored through integrated sensors and real-time analysis software to identify the different types of materials and components. Integration with a machine-learning system makes it possible to identify recurring patterns in board composition and to improve the efficiency of the recycling process. Tracking such information is essential to ensure that PCBs are correctly separated and managed for optimal material recovery.

To ensure environmental sustainability, the system includes an energy monitoring module that detects consumption in real time and adapts operating parameters to minimize waste. During manufacture of the PCB boards themselves, throughout the various steps that move the fiberglass laminate substrates through screen printing, component insertion, Automated Optical Inspection (AOI), and final assembly, barcodes and/or QR codes are applied to the boards in order to encode information on when and where a board was manufactured, soldering temperature, flux density, board type, material composition, component density, disassembly data, component lot numbers, and test data. Tracking this information is essential to ensure that the PCB boards have been assembled correctly and with all necessary components. Consequently, acquisition of such data and their processing at station 101 makes it possible to optimize, facilitate and accelerate the subsequent disassembly process performed by the automated platform.

In order to read such information, within a sub-process referred to as VISTA (Visual Inspection and System for Testing and Archiving), the PCB boards are conveyed through a multidimensional analyser consisting of a tunnel equipped with a barcode and QR code reader and of an LED lighting system. The barcode reader is enabled to run reading algorithms of the 1DMax type with Hotbars and 2DMax with PowerGrid, and serves the dual function of identifying 1D and 2D codes printed on labels or printed/laser-engraved directly on the boards, and of reading information not embedded in the original barcode label. Such advanced algorithms ensure higher accuracy than conventional systems, enabling faster and more reliable decoding even under low-light conditions or with partially damaged codes. The collected information is sent to the central management software, or MES, which classifies the PCB board by searching a database for the manufacturing information. In the event of discrepancies between the read data and the recorded data, a cross-validation system checks the reliability of the information prior to definitive archiving. Where the information is not available in the database, the detected data are catalogued for future recognition. The PCB board is then conveyed out of the reading gate towards the subsequent storage station 102.

According to one aspect of the invention, said PCB board storage station 102, schematically shown in Figure 2, is referred to as a Board Handling Module, by means of which the automated platform, based on the information received, stores the boards in the rack modules 102a according to their different characteristics. This function is strategic because it allows improvement of the raw-material and electronic-component recovery process, as well as ensuring lower expenditure of time and energy and thus a higher level of environmental protection. The rack modules 102a, identified by a unique code, for example a QR code or an RFID tag, are of the slide-out type and are provided with a motorized side wall that adapts their dimensions to those of the PCB boards to be handled. A self-calibration system dynamically adjusts the opening and closing of the walls to ensure optimal clamping without damaging the boards. In addition, said modules are positioned so as to be easily retrievable depending on the type of PCB board to be handled. The Board Handling Module, in fact, calls up the reference rack 102a, which is placed on an automatic lifting system whose function is to bring the first free slot to the level of a PCB transfer trolley. The board to be stored is then pushed into the slot of the rack module 102a by means of a mechanical pusher arm, which is equipped with pressure and positioning sensors to ensure precise and safe insertion of the boards into the slots. Once the rack has been loaded, it returns to its original position, leaving room for another rack meanwhile called up by the MES application according to the characteristics of the next board. Once all available slots have been used, the respective rack 102a is moved, by means of a dedicated transfer system, to a staging area while awaiting subsequent processing. An RFID tracking system allows the position and status of each rack 102a to be monitored in real time, optimizing space management and warehouse logistics. In order to increase the eco-sustainability of the process, a specific energy-optimization module dynamically regulates the power supply of the machinery according to actual production demand, thereby reducing overall energy consumption. Furthermore, the integration of recycled materials in the mechanical components of the machine increases its environmental sustainability.

According to another aspect of the invention, the third disassembly station 103, in a sub-process referred to as CATS (Controlled Atmosphere Teardown Station), is designed to strip the PCB boards of all electronic components present thereon, in order to simplify the subsequent processing stages, as well as to recover ,through a subsequent process, specifically in the fourth analysis and separation station 104 ,the reusable electronic components by separating them from those that are recyclable, while ensuring high energy efficiency.

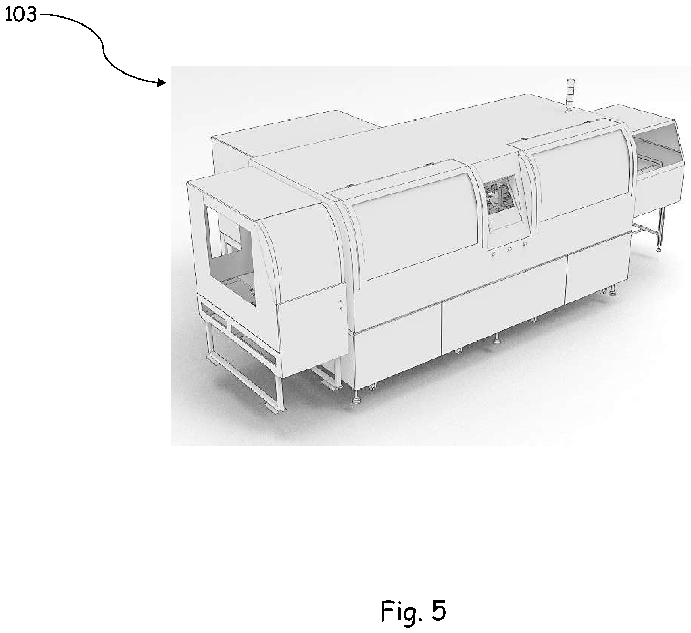

According to one aspect of the invention, in said third station 103, schematically shown in Figure 5, the PCB boards are transferred to the disassembly station 103 in the racks 102a assembled in the previous stage by the Board Handling Module into homogeneous categories. A camera located upstream of station 103 detects the QR code applied to the racks 102a and transmits the data to the central MES management software in order to receive the work instructions. The rack 102a is lifted and introduced into a vertical tunnel, where the PCB boards are fed sequentially onto a suspended dual-rail carriage. The multi-level loader allows multiple PCB boards to be processed simultaneously, reducing waiting times and increasing productivity by up to 200% compared to similar solutions. The dual-rail handling system, expandable up to four rails, allows multiple boards to be loaded, reducing downtime between cycles thanks to the integration of a continuous loading buffer, which automatically pre-arranges incoming boards so as to maximize operational throughput. To facilitate detachment of the electronic components, the boards are positioned upside down, optimizing heat flow and force distribution during the process. The dual-rail carriage has adjustable walls whose function is to clamp the board securely and centre it with respect to the working area. Carriage motion is controlled by a toothed-belt system, ensuring precision and smooth transport up to the next stage. A variable-reluctance motor, high-efficiency and with dynamically regulated inverter, ensures reduced energy consumption and improves motion accuracy. A kinetic energy recovery system further allows the energy generated during deceleration phases to be reused to power motors of other sections of the machine, further optimizing overall efficiency. The PCB boards are pre-heated by means of an IPH infrared module (Infrared Pre-Heating), consisting of a system of radiant panels distributed uniformly above and below the board, ensuring homogeneous and controlled heating. The infrared emitters are strategically positioned toto optimize heat transfer towards critical areas, reducing energy dispersion and ensuring a uniform temperature across the entire surface of the PCB board. The IPH system is assisted by an advanced heat-recovery system, which exploits the thermal energy dissipated during the cooling phase of the boards at the end of the process, thereby reducing overall energy demand. Liquid-to-air heat exchangers further optimize efficiency, while an advanced PID-based control dynamically modulates the emitted power, adjusting the intensity of the emitters according to the specific characteristics of the board in order to prevent localized overheating. A forcedconvection preheating system reduces heating time by 30-40%, further accelerating the process and improving the thermal stability of the PCB boards.

The PCB boards then enter a sealed working chamber, built from high thermal-resistance materials and provided with an insulation system to prevent heat losses. The inner walls are lined with stainless-steel panels treated to resist corrosion and ensure system durability. A hermetic closing system with highseal gaskets prevents vapor leakage and ensures thermal stability within the working chamber.

The process inside the chamber takes place in several stages. Initially, a heat-transfer fluid is heated up to its specific boiling point, generating a saturated vapor environment that uniformly envelops the board, ensuring extremely precise thermal control. Heating is carried out by means of an immersion electric resistance system, designed to ensure a stable and uniform fluid temperature. High-precision temperature sensors, positioned both inside the heating tank and along the distribution circuit, continuously monitor the thermal parameters, regulating in real time the power supplied to the resistances so as to maintain the fluid at the optimal temperature.

Subsequently, an intelligent heat-transfer-fluid distribution system ensures optimized vapor delivery, preventing accumulation in specific areas and improving process uniformity. The generated vapor acts directly on the solder joints, transferring heat uniformly and causing the solder alloy to melt. During this phase, the reduced surface tension prevents random reflow, promoting clean detachment of the components without damage.

In order to prevent molten solder amalgam from flowing into the heat-transfer-fluid tank, the chamber is provided with a gravity separation system that allows solder particles to settle in a dedicated area without interfering with the process fluid. A suitably positioned coarse-mesh metal filter ensures that only the finest particles are captured and conveyed to a separate collection system, optimizing solder recovery and keeping the heat-transfer-fluid tank clean.

Movable baffles with variable geometry dynamically regulate the vapor flow, ensuring effective and homogeneous heating in reduced times. A fast-response fluid evaporation module accelerates vapor formation and ensures faster saturation, reducing overall process duration.

Advanced fluid recovery is carried out through multi-stage condensers, allowing reuse of up to 70% of the employed fluid, significantly reducing operating costs and environmental impact. The optimized vapor distribution system ensures uniform heating in reduced times, improving process stability and ensuring the integrity of the treated electronic board.

During said phase, a selective micro-aerodynamic jet applies an ultra-thin film over the entire PCB board, temporarily reducing the surface tension of the solder without altering its chemical composition. This step facilitates component detachment in the subsequent phase. A top-down ventilation system guides vapor deposition onto the soldering side, optimizing heat transfer and ensuring uniform heating of the relevant surface. An ultrasonic vibration system reduces solder surface tension, further improving component detachment. This process is synchronized with an AI thermographic monitoring system, ensuring that detachment occurs under ideal thermodynamic conditions.

When electrical and electronic components begin to detach, the thus-heated PCB boards advance to an intelligent suction system, which selectively removes components already separated, avoiding interference with those still in the release phase. Suction is managed by a PLC-controlled vacuum motor, which calibrates suction force based on the type and size of the components. To ensure safe collection, an ultra-thin metal-mesh filter prevents damage to the most delicate components. The removed components are deposited into a sectorized collection drawer, where they are automatically separated according to size, before being conveyed to the subsequent fourth analysis and separation station 104.

After separation, the now bare PCB board is rapidly discharged from the machine and transferred to a separate cooling module. The external cooling system uses liquid-to-air heat exchangers to recover the boards' thermal energy and transfer it to the preheating system, further reducing energy consumption. Pulsed compressed air accelerates cooling without compromising PCB integrity, while a motorized roller conveyor transports the PCB boards to the collection point for subsequent disposal or recycling of non-recoverable materials.

Vapours generated during the process are treated by an advanced filtration system combining HEPA and activated-carbon filters. To further reduce environmental impact, the MES control module continuously monitors outlet air quality and automatically regulates filtration flow, also thanks to the integration of a thermal condensation module that captures solvent residues, reducing emissions. The condensed fluid is collected in a recovery tank and subjected to multi-stage filtration, enabling reuse of up to 70% of the fluid, lowering operating costs and minimizing environmental impact. The entire The entire CATS sub-process is continuously monitored by an Online Temperature Recording Software (TRS) data-logging software module, included within the supervisory layer of the central management software, i.e., the MES control module. Such dedicated module not only tracks thermal profiles and operating parameters, but is also capable of flagging in advance any anomalies or thermal drifts. Thanks to the implementation of advanced IoT sensors, the CATS sub-process includes a sophisticated predictive-maintenance system, which detects in real time the condition of critical components such as carriages and motion guideways, preventing failures and optimizing the productivity of the entire automated platform.

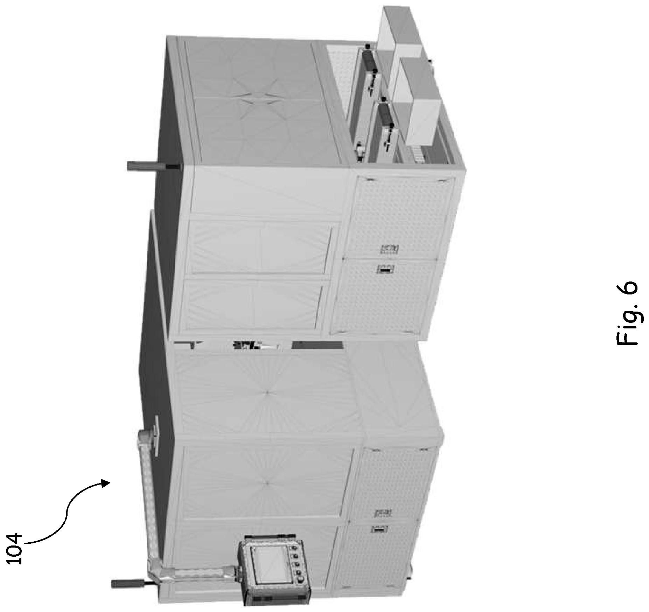

According to another aspect of the invention, in the subsequent fourth analysis and separation station 104, schematically shown in Figure 6, within a sub-process referred to as RISE (Recovery & Integrity Screening for Electronics), carried out in a clean-room environment to ensure the absence of contaminants, the electronic components removed from the PCB electronic boards in the third station 103 are subjected to a dedicated process whose purpose is to recover the functional and reusable components by separating them from those that are recyclable and not suitable for reuse. In particular, within the fourth station 104 the disassembled electronic components are sent to a further stage of dimensional separation and prehomogenization. A combined system of rotary, vertical and horizontal motion subdivides the components into homogeneous groups by size, ensuring a uniform flow in subsequent stages. Separation is supported by a differentiated airflow system, which discriminates materials based on density and specific weight, preventing elements made of different materials but having similar sizes from mixing. The management system is based on adaptive artificial intelligence, which analyses the parameters of incoming components and dynamically optimizes the separation process.

Once subdivided, the electronic components are automatically transferred to the subsequent phase of analysis and functional selection. To this end, a dedicated analysis system comprises a multidimensional optical analyser that performs an advanced assessment of the structural integrity and physical characteristics of each component. The system uses Deep Learning Vision technology, supported by a multispectral scanning system, and allows detection of micro-cracks, oxidation and chemical alterations that would not be identifiable through conventional visual inspection. In addition to aesthetic and mechanical verification, a dielectric-variation sensor performs an internal structural analysis of the semiconductors, identifying any invisible deep defects.

Components found compliant with predefined standards are transferred to the functional testing stage, while those exhibiting anomalies are immediately diverted to the recycling stream. Suitable electronic components are then subjected to an induction conductivity test, a technology that allows verification of electrical integrity without the need for physical contact. The system generates an alternating magnetic field and analyses the component's electromagnetic response to identify circuit interruptions, defects in connection pins, or oxidation issues in electrical contacts. The machine is equipped with an adaptive detection system enabling testing of components with different electrical characteristics without requiring manual calibrations. Based on the results, the functional components are picked by an automated separation system comprising self-moving blowing nozzles, and are transferred to the cleaning and packaging stage, at the fifth cleaning station 105, while defective components are conveyed to a subsequent sixth granulation station 106 for raw-material recovery.

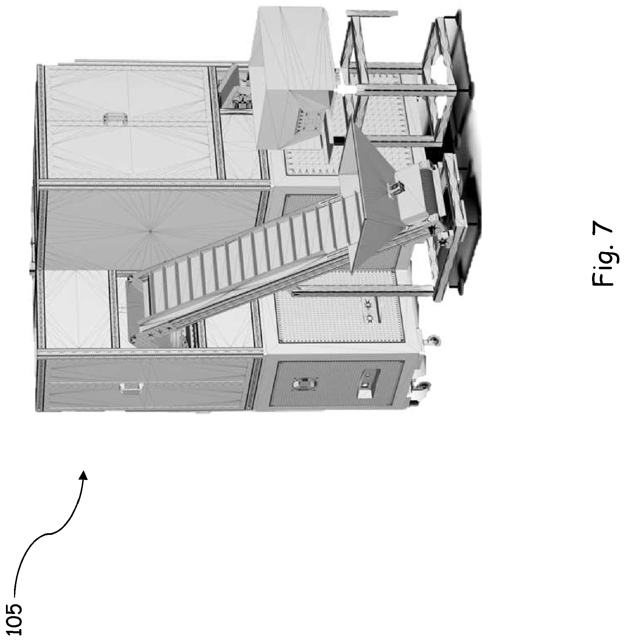

According to one aspect of the invention, in particular, reusable electronic components that can be reintroduced into a secondary production cycle are routed to the subsequent fifth cleaning station 105, schematically shown in Figure 7, which in fact constitutes a branch with respect to the in-series arrangement of stations 101, 102, 103, 104, 106, 107, 108, 109. The electronic components suitable for reuse undergo an advanced dry ultrasonic cleaning treatment, designed to remove any oxidation residues, impurities, or surface contamination. The effectiveness of the treatment is ensured by the combined action of ultrasonic cavitation, micro-vibrations and ionized-air jets, which remove impurities without the use of solvents or liquids, preserving the quality of the treated materials. Upon completion of cleaning, the electronic components are automatically catalogued and packaged, via a robotic module 105b that manages packaging and labelling by means of QR codes or RFID tags, enabling full traceability throughout the distribution chain.

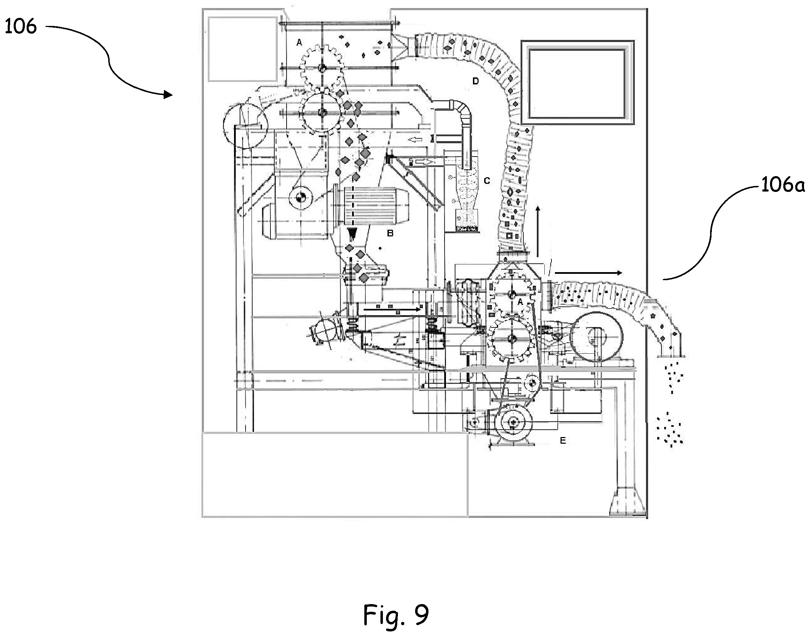

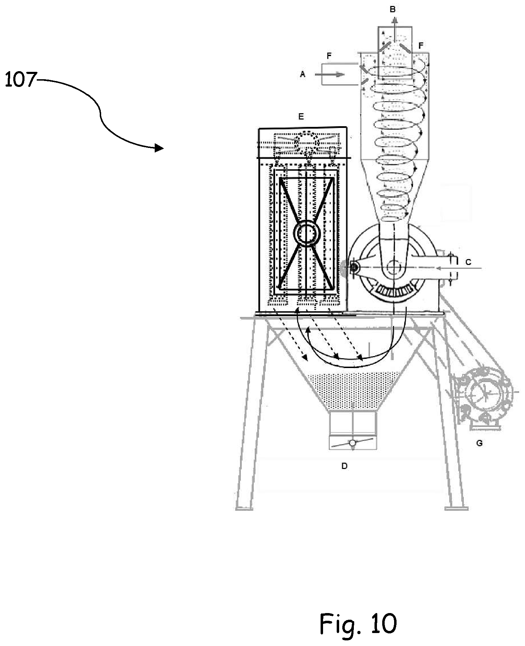

According to another aspect of the invention, in the subsequent sixth granulation station 106, shown in Figure 9, a granulator stage is tasked with crushing bare PCB boards (bare boards) and electronic components not suitable for reuse in a homogeneous manner, transforming them into uniform fragments having a size between 5 mm and 10 mm. The purpose of this processing is to facilitate the subsequent pulverization of the material in an orbital micronizer, part of the subsequent seventh station 107, schematically shown in Figure 10. The granulator stage is equipped with variable-speed rotating blades, which automatically adapt to the resistance of the processed materials, avoiding the risk of undesired pulverization and ensuring controlled size reduction.

To maximize process energy efficiency, the granulator is equipped with an energy recovery system, which allows reuse of part of the energy generated during grinding and leverages a regenerative braking system that converts the kinetic energy of the process into electrical energy. This is used to power the modules of the entire granulator. In addition, the heat generated by the granulator's electric motor is recovered and used for preheating the compressed air utilized in other process stages, significantly reducing overall energy consumption.

Once granulation is completed, the obtained material is collected in holding tanks, which ensure a continuous and regulated feed flow for subsequent processing stages. The entire granulation station has been designed to be compact and efficient, with a vertical structure that reduces footprint and optimizes operational flow. The layout provides a functional organization of the processing sections, with holding tanks positioned above the granulator so as to exploit vertical space and improve weight distribution. Interconnection between the different process stages takes place directly, avoiding unnecessary handling and increasing overall productivity. Integration of the energyrecovery system and advanced automation makes it possible to drastically reduce energy consumption and improve process sustainability.

According to another aspect of the invention, the granulator stage is also provided with a software module intended for setting, controlling and managing the entire sub-process. Connected to the central MES management software, already integrated with artificial intelligence, said module enables real-time intervention on key parameters such as processing time, revolutions per minute, and fill level. Fill-level control is made possible by a probe which, upon detecting potential overload conditions, causes closure of a dedicated valve and slows down the throughput and speed of the conveyor belt.

Once the correct amount of material to be processed has been loaded, the granulator is activated. In a lower portion thereof, the sixth station 106 is provided with a sieve 106a enabling discharge of particles having compatible size, while the material remaining in the granulator continues to be comminuted until the set size is reached. The rotating-blade cutting system is optimized by implementing self-regenerating and self-adaptive blades, made with a coating based on nanostructured materials capable of reducing wear and extending operational life. Furthermore, blade geometry is variable and automatically adapts as a function of the type of material being processed, improving comminution efficiency and reducing energy consumption.

The granulator is equipped with a piezoelectric system that converts the mechanical vibrations generated by the comminution process into electrical energy, which can be reused to power the electronic systems of station 106, reducing overall consumption. The granules obtained are discharged through a vibrating chute and collected in dedicated tanks. During comminution, fine dust potentially harmful to product quality and workplace safety is generated. For this reason, the granulator is equipped with an extraction and filtration system, comprising high-efficiency cartridge filters and cyclones for separation of the coarser particles. To improve operating comfort, the granulator incorporates an active acoustic-reduction system based on innovative sound-absorbing materials and a noise-cancellation module. Such system significantly reduces the acoustic impact of the granulation station, improving operators' working conditions and making the granulator suitable also for installations in environments with restrictions on noise emissions.

According to another aspect of the invention, in the subsequent seventh pulverization station 107, shown in Figure 10, the above-mentioned orbital micronizer, intended to pulverize the incoming fragments produced by station 106, initiates the first part of the particle-size reduction process and the recovery of certain precious metals. On PCB boards, and in certain electronic components, precious metals such as gold, silver and palladium may in fact be present in the form of plating a few microns thick generally applied on copper or aluminium pins in order to increase conductivity and protect them from oxidation. The micronizer is further designed to ensure complete exfoliation of the plantings without dispersion of ultra-fine particles, optimizing their recovery in subsequent stages.

In the micronization process, target results are determined by the central MES management software, defined on the basis of the composition of the incoming material. The system uses its own PLC, like the other workstations of the platform, interfaced with a SCADA (Supervisory Control and Data Acquisition) system that allows real-time management and supervision of the entire process. The SCADA acquires data from sensors distributed in pulverization station 107, providing a detailed visualization of operating parameters through an advanced user interface. Furthermore, said SCADA architecture provides historical data analysis, anomaly identification, and implementation of automated optimization strategies. Connectivity with the MES control software module also ensures seamless integration between production management and real-time parameter control, improving overall process efficiency.

In particular, the central MES management software intervenes in the pulverization/micronization sub-process by calculating processing time according to the characteristics of the material to be micronized, providing instructions and controlling the intermediate phases, continuously acting on setting parameters such as air velocity for material fluidization, monitoring and regulating the operating temperature so that it remains below 70°C in order to prevent overheating and melting of plastic microgranules. Regulation is adjustable even with the cycle already started, allowing precise variations in micronization by acting on air-flow velocity and on a dynamic classifier. The micronizer is tuned to obtain a particle size distribution between 1 µm and 50 µm, an interval optimized to promote separation of gold from the copper base without excessive fragmentation.

The seventh pulverization station 107 has a cylindrical structure with at least two superposed chambers, having a diameter and an overall height suitable for the quantity of material to be processed. Operation is entrusted to one or more high-efficiency electric motors connected to a centrifugal compressor that supplies the air flow required for micronization.

The pulverization/micronization sub-process begins with loading of the material from above by means of a hopper provided with a hermetically sealed pneumatic valve, which prevents dust leakage and ensures a controlled flow of the fragments. In order to prevent contamination of the micronization chamber with fine dust, the loading outlet may further be equipped with a dust abatement system provided with compressed-air pulse jets, ensuring automatic removal of accumulated particles. Loading is performed with the machine stopped and with the micronization chamber completely empty.

Filling, in order to ensure adequate fluidization and optimal control of micronization, may be carried out up to a maximum of 20% of the total volume of the working chamber.

Such value is determined through computational fluid dynamics (CFD) simulations and calculations based on Stokes' law, which governs the settling of particles in a fluid: $v_s = \left(2/9\right) * \left(\left(ρ_p-ρ_f\right)*{g * r}^{2}\right) / η ,$
where "v_s" is the settling velocity;
"ρ_p" and "ρ_f" are respectively the density of the particle and of the fluid;
"g" is gravitational acceleration;
"r" is the particle radius;
and "η" is the fluid viscosity.

Prior to the micronization phase, in order to ensure that precious-metal particles having high density are separated from lighter materials, a pre-treatment is started. The particles are subjected to high-frequency vibrations together with intermittent high-pressure air jets, which promote preliminary detachment of the plating from the pins without causing excessive pulverization. Upon completion of this phase, which lasts a few seconds, the particles are subjected to a circular flow of air or nitrogen, injected into the micronizer by means of a set of nozzles that generate air streams having differentiated velocities and pressures, creating a highly turbulent environment in which the particles collide with one another and with the micronizer walls. Collision-induced fragmentation is the key principle of this process in order to obtain a controlled particle size distribution. When particles collide with one another and with the micronizer walls, part of the energy is dissipated as heat, part as deformation, and part as fragmentation.

The station is designed to maximize the number of collisions required for particle-size reduction, balancing the energy imparted by the air flow with the particle break-up rate. The combined and opposing action of the air and the orbital force of the fragments inside the micronizer, set according to suction flows and controlled pressure drops, allows collision-based comminution and product fluidization until a particle size is achieved that ensures, in subsequent processing, isolation of the individual materials.

The nozzles are made of a material suitable to withstand wear due to the high velocity of the micronized particles and are strategically positioned at defined points of the micronization chambers.

A set of nozzles is positioned about 30 cm from the base of the micronizer and is suitably inclined to generate a high-pressure flow, about 6-8 bar, and high velocity, up to 480 km/h, promoting collisions among the larger particles. Intermediate nozzles, arranged at about 1.2 m from the base, have an adjustable inclination between 30° and 60° and operate at a slightly lower pressure, between 4 and 6 bar, to maintain fluidization of the finer particulate, thereby reducing the risk of agglomeration and improving energy distribution. Upper nozzles, finally, are positioned in the upper part of the chamber and directed radially; they are supplied at low pressure, between 1 and 3 bar, and ensure suspension of the lighter particles without altering the distribution of precious metals. The internal configuration of the micronizer imparts an orbital motion to the material impacted by the perpendicular trajectories of the flow, thereby increasing grinding efficiency.

In order to avoid excessive pulverization of gold, which could compromise recovery, air velocity and processing time must be adjusted so as to obtain gold particles preferably between 10 µm and 30 µm, whereas copper will tend to fragment into larger granules, between 20 µm and 50 µm.

To prevent overheating of plastic material and to keep temperature stable, the system integrates a thermal monitoring system with predictive algorithms to anticipate temperature variations and optimize cooling; more in detail, one or more of the following systems may be adopted:
- a refrigeration-cycle heat exchanger on the process-air circuit to cool incoming air to 5°C-10°C;
- controlled injection of liquid nitrogen (LN₂) to lower temperature during critical phases;
- a cooling jacket with temperature-controlled heat-transfer fluid (water + glycol) to dissipate heat generated by particle friction.

In each of the above cases, PT100 temperature sensors are provided to monitor and dynamically regulate thermal parameters based on material composition.

The air used in the work cycle is continuously cleaned and recycled through the use of a multi-stage filtration system with sensors for monitoring fine particles, ensuring greater air purification efficiency.

To optimize gold separation, the high-speed dynamic classifier must be calibrated to exploit gold's higher density, equal to 19.3 g/cm³, compared to copper (8.96 g/cm³) and to other present materials such as fiberglass and resins. This makes it possible to collect gold separately from lighter metallic fragments, preventing its dispersion into fine dust.

During processing, light particles such as fiberglass, resins, and certain plastic materials tend to locate in the upper portion of the micronizer and are discharged through a combined system of cyclones and membrane filters, ensuring more effective separation than discharge ports alone. Each port, integrated with the filtration system, is provided with an electric valve which, controlled by the PLC of station 107, is opened for a few seconds at predefined intervals. The material is collected in dedicated bags, ensuring reduced dispersion and higher separation efficiency.

Heavier fragments, consisting of plastics and metals, tend to settle in the lower portion of the second, elliptical chamber, where the material passes through a system of differentiated cyclones arranged symmetrically on the sides of the micronizer and in proximity to the discharge area. Such arrangement makes it possible to manage the air flow in a balanced manner and to optimize separation of precious-metal particles previously exfoliated. The primary cyclone, having a larger diameter, is installed directly beneath the micronization chamber and serves to separate the heavier metal particles by exploiting the centrifugal force generated by the air flow, directing them to the collection system for subsequent refining. The secondary cyclone, of smaller size, is positioned adjacent to the primary cyclone and is responsible for capturing fine plastic and resin dust, preventing dispersion of valuable particles.

The exfoliated material, consisting of particles of a few micrometres, does not settle directly in the lower part of the micronizer by gravity, but is handled through a controlled air flow that governs its separation and recovery. The process logic provides that denser particles, such as precious metals, are directed towards the primary cyclone due to their higher inertia and the centrifugal force generated by the air flow. Such phenomenon is regulated by Stokes' law, which establishes the settling velocity as a function of particle density and size.

Lighter particles, such as plastics and resins, are maintained in suspension longer and diverted towards the secondary cyclone, which operates at lower pressure to ensure selective capture. The entire system is calibrated on the basis of data collected from CFD simulations, which made it possible to identify the optimal air-flow parameters to avoid dispersion of the finest particles and to ensure that precious metals are conveyed to the recovery zone without incurring losses in the filtration system.

Both cyclones operate in synergy with a variable-control centrifugal fan that regulates the air-flow velocity within the cyclones according to operating conditions monitored by the MES control software module. The structure is made from materials capable of withstanding wear and abrasion. The dual-cyclone configuration reduces the risk of clogging and provides higher separation efficiency compared to a single cyclone system.

The high-speed dynamic classifier, positioned downstream of the cyclones, exploits the density difference between precious metals and the other materials to ensure effective separation. The classifier is composed of a variable-speed rotor and a set of directional vanes and operates at high speeds, optimizing air flow and enabling selective separation of the heavier metallic fractions.

An electrostatic capture system applies a high-voltage potential difference to attract and collect ultra-fine precious-metal particles, improving recovery of the lightest fractions. The system comprises three main elements: collection electrodes, a voltage generator, and a discharge system for the separated particles. The electrodes, made of stainless steel with a dielectric coating to prevent short circuits, are strategically positioned along the particle path to maximize capture efficiency. The high-frequency voltage generator maintains a stable potential difference, dynamically regulated by the PLC of station 107 to adapt to variations in particle charge.

The charged particles are attracted to the electrodes and subsequently released through an air-pulse cleaning system or via controlled mechanical discharge. The recovered material is then conveyed to the collection compartments for subsequent refining. Construction variants include systems with cylindrical electrodes to increase collection surface area and versions with vibrating plates to prevent particle accumulation on conductive surfaces. Dynamic regulation of the system is managed by the PLC in connection with the MES control software module, which continuously monitors operating parameters and adapts separation conditions to maximize recovery efficiency.

To improve process efficiency, the system includes a differentiated discharge mechanism with timed valves, enabling selective collection of micronized particles according to density and particle size distribution. The discharge mechanism consists of a set of hermetically sealed electric valves, PLC-controlled, which open sequentially so as to avoid mixing of the different material fractions. The valves are made of a resistant material and are provided with gaskets suitable to ensure resistance to wear and corrosion.

The heavier particles are conveyed to a hopper collection system with controlled vibration, which facilitates material transfer without risk of clogging. The finer material, on the other hand, is collected through an air stream channeled towards a secondary cyclone filter that optimizes separation prior to the final recovery stage. Pulverization station 107 may be configured with different construction variants, including a double pressurized-chamber discharge unit to reduce dispersion of fine dust, or direct pneumatic conveying towards storage containers. The set of components ensures precise regulation of micronization and optimized recovery of valuable materials, with the possibility of adapting the discharge mechanism as a function of the characteristics of the treated material.

Upon completion of the processing cycle, the ready material is discharged through a series of ducts into dedicated tanks that feed, in sequence, the subsequent eighth station 108 for separation of raw materials.

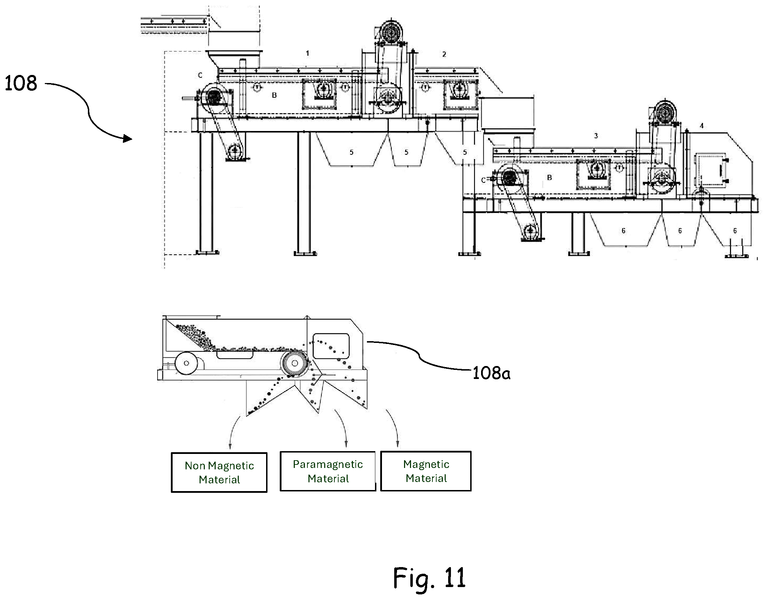

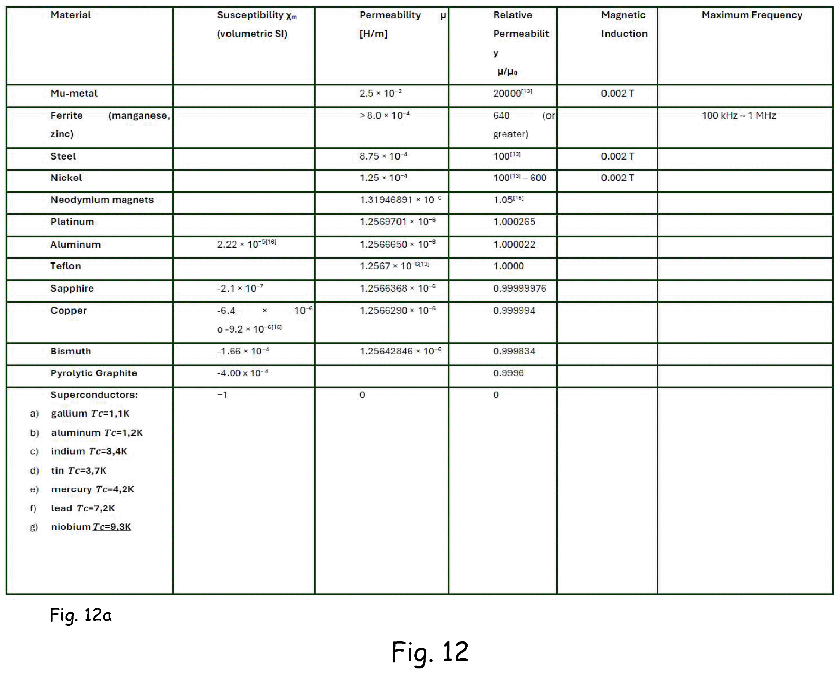

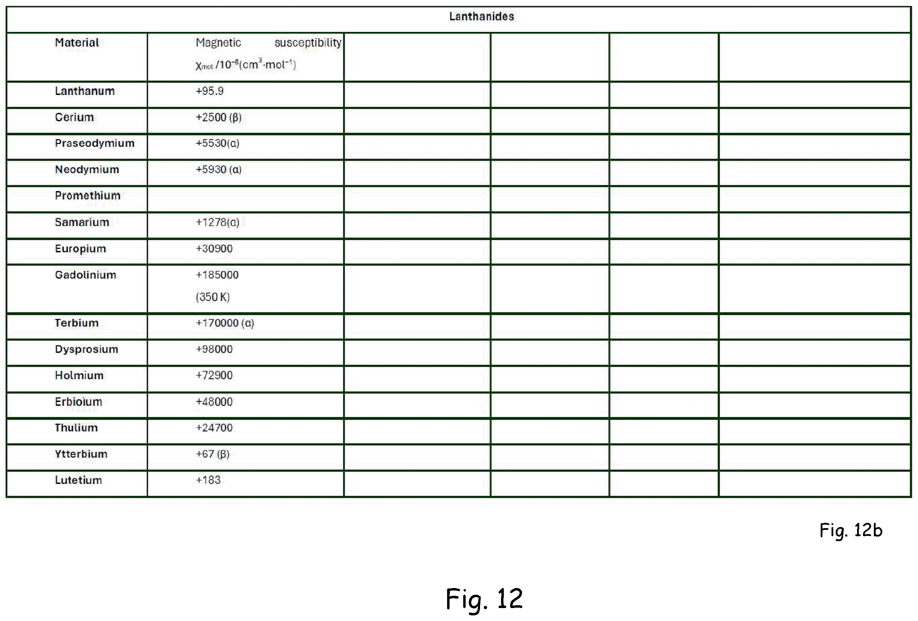

According to one aspect of the invention, said eighth station 108, visible in Figure 11, receives from pulverization station 107 fragments of material whose shape and size are such as to ensure the presence of single-component particles, and comprises a series of magnetic separators 108a. Such processing stage of the automated platform, which is the subject matter of the invention, exploits magnetic susceptibility, "χ_m", i.e., the overall magnetic moment of the various materials present in the mixture to be separated, materials listed by way of example in the table schematically shown in Figure 12, which describes the ability of a substance to become magnetized in the presence of a magnetic field.

According to one aspect of the invention, station 108 is managed by the modelling platform of the central MES management software, which controls and reconfigures the recycling process chain as the composition of the mixture being processed varies. Operating on micrometric fragments, station 108 operates in an isolated environment to prevent contamination of the external environment with dust and other volatile materials. Ferromagnetic materials, such as iron and nickel, have high magnetic susceptibility χ_m and are readily attracted, whereas paramagnetic and diamagnetic materials respond more weakly or oppositely to the applied field, making precise adjustment of separation parameters necessary.

A magnetic separation stage 108a consists of a distributor located at the inlet, whose function is to distribute the material coming from a storage silo. The distributor has been optimized with a vibrating system featuring fluidizing channels to ensure uniform distribution of the material. Such system, combined with micro-jets of an inert gas such as argon or nitrogen, reduces cohesive forces among particles having sizes between 10 µm and 50 µm, improving flowability and preventing formation of agglomerates. Real-time density sensors dynamically regulate vibration intensity in order to adapt to the quantity of incoming material, ensuring a constant and uniform flow. Moreover, to further optimize distribution and prevent build-ups, the system is fully integrated with the MES control software module, which monitors and regulates material throughput in real time. An active flow-rate control based on AI algorithms allows automatic adjustment of vibration frequency and of micro-jet gas pressure according to the characteristics of the batch being processed, ensuring dynamic adaptability and efficient distribution. Furthermore, to ensure optimized operation, the system provides energy recovery from the motors of a drum and from the demagnetization circuit. Continuous monitoring of energy consumption allows balancing operating efficiency with energy expenditure, dynamically adjusting process parameters to minimize waste.

The material is conveyed to a magnetic drum for progressive and optimized separation. The drum is provided with an advanced system of internal movable magnets, whose position can be modified by shifting them from the inside towards the outside, and vice versa, to amplify or reduce the magnetic field according to separation needs, in accordance with the Ampère-Maxwell law, which establishes that a magnetic field can be generated by an electric current or by a variation of an electric field. To improve the stability of station 108, guide rails and actuators are provided that minimize vibrations and misalignments during operation. Real-time position sensors ensure accurate magnetic-field adjustment, reducing any intensity fluctuations. Furthermore, magnetic intensity can also be regulated by varying the number of active magnets or by modifying drum rotation speed, allowing more precise and dynamic control of the separation process. For even finer regulation, a magnetic-field modulation system by means of coils is provided, exploiting the Lorentz force describing the interaction between a magnetic field and a moving charge. This system allows real-time field adjustment depending on the type of material being processed. An advanced PID control synchronizes drum speed and field intensity, ensuring optimal separation without dispersion. The entire system is controlled by the central MES management software, which adapts operating parameters in real time based on the preliminary analysis of the composition of the mix to be separated.

Made of AISI 304 stainless steel and coated with an antiwear polymer, the drum houses Neodymium-Iron-Boron (NdFeB) magnets with real-time adjustable magnetic intensity. Field intensity, in detail, varies between 1.5 T and 2 T for nickel separation, between 0.6 T and 1 T for chromium, and between 0.3 T and 0.6 T for iridium and other paramagnetic elements, with alternating N/S/N/S polarity optimizing attraction effectiveness. However, to eliminate any residual magnetization in the separated paramagnetic materials, an active demagnetization circuit is positioned at the outlet of the drum. This principle is based on the magnetic hysteresis loop, which describes the behavior of ferromagnetic and paramagnetic materials when exposed to a varying magnetic field. To further improve process effectiveness, station 108 uses a dual demagnetization coil with alternating polarity, ensuring more effective release of weakly magnetic materials. In addition, outlet magnetic-field sensors dynamically monitor residual magnetism, enabling automatic adjustment of demagnetization intensity to maximize release effectiveness. This system uses a demagnetization coil that generates a low-intensity alternating magnetic field with decreasing frequency, gradually neutralizing residual magnetism in the treated materials according to the principle of demagnetization with pulsed fields. Dynamic coil regulation makes it possible to adapt the demagnetization process based on the specific characteristics of the separated material, ensuring more effective release and reducing the risk of undesired retention.

A number of Hall sensors are used to measure the intensity of the magnetic field generated in the drum, detecting field variations by converting them into electrical signals, thus allowing real-time adjustment of field intensity according to separation parameters required. This physical principle states that a transverse voltage is generated when a current-carrying conductor is placed in a perpendicular magnetic field. Their function is essential to ensure correct modulation of magnetic force and to optimize material selection, avoiding dispersion or inefficiencies.

A pulsed magnetic-gradient separation stage provides high selectivity in capturing weakly paramagnetic materials such as platinum and palladium. Such method exploits a variable magnetic field applied in pulses to modify the interaction of paramagnetic materials with the drum. By adjusting the frequency and intensity of the pulses, separation can be optimized according to the specific characteristics of the processed material. Controlled variation of the magnetic force makes it possible to increase separation selectivity, avoiding accidental retention of undesired materials and improving overall process efficiency.

To ensure that temperature remains optimal throughout all processing stages, station 108 is equipped with infrared thermal sensors that monitor internal temperature in real time. In addition, an inert-gas cooling circuit, such as argon or nitrogen, is activated by the MES control software module when thermal variations are detected that could affect separation or the quality of the processed material.

Material not separated in the first pass is conveyed into a recirculation circuit. This loop allows modification of roller settings and magnet configuration, refining separation with specific parameters. The recirculation system is provided with verification and refining instruments for the material before it is reintroduced into the cycle. Material not recovered is transferred to an electrostatic separation stage.

The latter exploits differences in conductivity among materials by means of a drum made of conductive material and having a diameter proportionate to requirements. A tungsten wire electrode generates a variable voltage between 10 kV and 40 kV. The frame is designed to reduce vibration and integrates tuned mass dampers to minimize structural resonances. The stage operates in a sealed environment to avoid dust dispersion and external contamination, and is provided with a series of sensors for optimal temperature control, which automatically regulate process parameters to ensure stable operating conditions. In addition, high-absorption elastomeric supports reduce vibrations transmitted to the frame, improving operational stability, while a dynamic drum-balancing system minimizes undesired oscillations.

The corona electrode charges particles in transit on a dielectric conveyor belt. Conductive materials, losing charge rapidly, are expelled by centrifugal force, whereas lessconductive materials remain adhered to the drum until removed by an electrostatic brush. Material not separated in the first pass is conveyed into a recirculation circuit, which allows recalibration of the applied voltage and electrostatic configuration to further optimize separation. This process ensures improved material recovery and reduced losses in the system. Capacitive sensors regulate optimal voltage in real time, while anti-adhesion carbon-fiber brushes prevent charge buildup.

Conductive materials not separated are further treated through eddy-current separation stages exploiting magnetic induction. A rotating drum, made of a dielectric composite material of fiberglass and epoxy resin, is provided with highenergy NdFeB magnets arranged in twenty alternating rows. To increase durability and reduce friction, the drum is appropriately treated with abrasion-resistant materials. Rotational speed, adjustable between 60 rpm and 3000 rpm via PID control, generates a variable magnetic field between 100 Hz and 1500 Hz. Field frequency is modulated to optimize separation, in particular: at low frequency, between 100 Hz and 300 Hz, for aluminium and zinc; at medium frequency, between 500 Hz and 800 Hz, for copper and tin; and at high frequency, between 1000 Hz and 1500 Hz, for silver, gold, platinum and palladium. Dynamic magnetic-field sensors modify intensity and frequency in real time, while an AI algorithm calibrates drum speed based on incoming material.

An advanced spectroscopic selection module uses LIBS (Laser-Induced Breakdown Spectroscopy) sensors to analyse chemical composition of the materials in real time. However, since the presence of fine dust in the working environment could affect measurement accuracy, said stage is provided with an automated optical cleaning mechanism. To ensure optimal operating conditions within the sealed chamber, a closed-loop ventilation and filtration system is also implemented, maintaining constant internal air quality and reducing the likelihood of dust accumulation on the sensors. Such system uses high-efficiency HEPA filters and a controlled flow of inert gas to stabilize internal pressure and improve the operational life of electronic components, as well as compressed-air or inert-gas jets to keep the LIBS sensor lenses free of particulate, ensuring reliable readings and consistent performance over time.

The LIBS system employs focused laser pulses to vaporize a small portion of material, generating a plasma whose spectral emission is analysed to identify the constituent elements. Such technology enables rapid and accurate identification of metallic materials, improving automated selection and reducing the need for subsequent analytical processes. Data collected by the LIBS sensors are processed by the AI system to dynamically optimize separation parameters according to the composition of the processed material.

Material not separated in the first pass is again conveyed into an intelligent recirculation circuit which, based on the composition analysis performed by the LIBS sensors, determines the optimal route for reprocessing. To avoid excessive workload on station 108 and to ensure continuous and efficient operation, the system implements a flow-balancing logic. If the amount of recirculating material exceeds a critical threshold, the parameters of separation parameters are dynamically optimized to increase first-pass efficiency, reducing the load on subsequent stations. If the detected composition indicates a prevalence of highly ferromagnetic materials, the material is redirected to the magnetic separation stage, where the magnetic-field configuration is dynamically adjusted to optimize particle capture. If, instead, the composition is characterized by paramagnetic materials or materials having low magnetic susceptibility, the material is sent to the pulsed magnetic-gradient separation stage, where said gradient is modulated to refine separation. Finally, in the case of materials having high electrical conductivity, the material is diverted to the electrostatic separation stage, where voltage and charge parameters are optimized to improve selection of conductive materials. Continuous flow monitoring, integrated in the MES control software module, ensures that the amount of circulating material does not exceed the machine capacity limits, reducing processing times and improving process stability.

In addition, the MES is provided with a predictive-maintenance system, based on vibration and wear sensors, which analyses operating data and forecasts any intervention needs before failures occur. Automated diagnostics detect deviations in operating parameters and trigger alarms or corrective adjustments, ensuring higher reliability of the overall process. In this way, dynamic optimization of separation is ensured, reducing waste material and improving recovery of precious metals and alloys.

Mixed particles are finally conveyed to the various separators in order to refine separation.

According to one aspect of the invention, the ninth station 109 for recovery of plastic material, schematically shown in

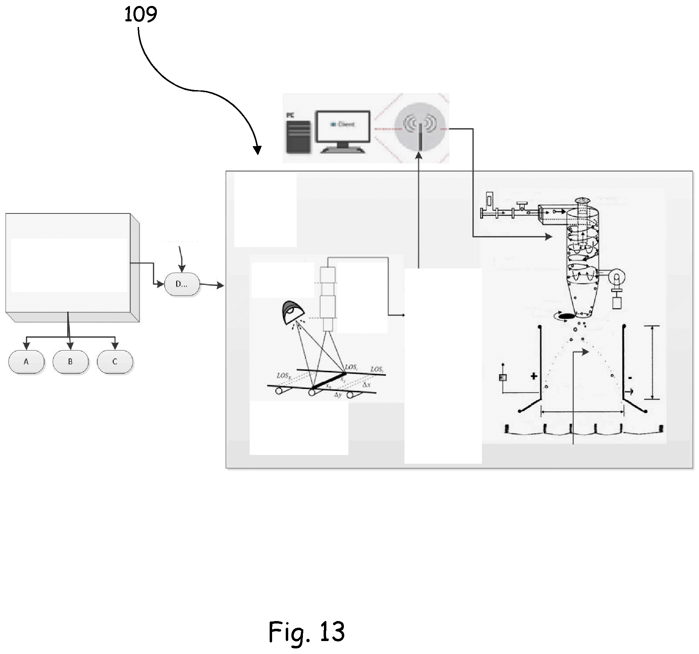

Figure 13, comprises an analyser module into which the lightest waste material, such as fiberglass, paper, resins, and certain plastic materials, recovered in station 107 during micronization is fed, in addition to the material not separated through the magnetic separation stage 108a.

In this residual material, referred to as "plastmix", there are generally present, in variable quantities, organic materials (OM) consisting mainly of polymer laminates based on thermosetting resins, epoxy or phenolic, inorganic materials such as fiberglass, ceramic and glass, and fractions of metals and solder material such as tin and lead.

The mixed fragments are then conveyed, on a mobile conveyor belt with adjustable speed, through a hermetically sealed tunnel and made to pass under a gate, specifically engineered, provided with a Raman spectrometer.

The latter is provided with a laser module and an opticalfiber reader and continuously detects the luminescence reflected by the analysed material, returning to the central management software, i.e., the MES control module, information regarding chemical composition, physical state and intermolecular interactions of said analysed material. The central management software, after verifying the analysis results, simulates alternatives regarding the treatment techniques to be used, identifying the settings of the subsequent stages that achieve the best possible result.

The material, in fact, after being analysed, is conveyed to a processing stage that exploits the principle of particle electrification by triboelectric charging (friction).

In such stage or sub-station there is included a metal cylinder, suitably sized according to the amount of material to be processed, made of steel. Closed at the top, said cylinder is provided with a throttling discharge solenoid valve positioned at the base, capable of controlling the flow rate of material exiting. To increase the inductive property, the inner walls of the cylinder are entirely lined with PET, which exhibits excellent chemical resistance, strength, rigidity, and resistance to wear and abrasion. The inner walls of the lining present a series of waves having thickness and depth increasing towards the bottom of the cylinder. The composition and the three-dimensional conformation of the inner PET walls have the dual purpose of enhancing the triboelectric induction effect (by friction) and controlling electron transfer by causing a greater distance between molecules.

Such structure also makes it possible to widen the interval, i.e., the gap, of the electrical charge among the particles depending on their molecular composition and thus on the propensity of the different materials to retain the induced magnetic charge for a longer time.

The stage further comprises a cyclonic blower positioned in the lower portion of the cylinder, which actuates an upward circular air flow to promote collision and friction of plastmix particles against the walls, thereby generating an electrical charge, and a separation unit consisting of a cylinder made of insulating material, provided with two high-voltage copper electrodes, capable of generating an electric field up to 400 kV/m. A further operating module included in the stage is finally a collection unit intended to separate the material.

Plastic-material recovery station 109 is continuously controlled by the MES control software module, which constantly compares initial simulation data with real-time data, intervening in the event of deviations. Such interventions are implemented by means of an electronic hygrometer that detects humidity present in the environment, controlling the air velocity introduced into the silo, controlling opening and closing of the material loading and discharge valves in the silo, controlling silo cleaning, and controlling electrode voltage.

More in detail, since water acts as a conductor, through constant humidity control by means of the hygrometer it is possible to limit the electrostatic charge of the particles, causing rapid balancing of electrical charges.

Control of the air velocity introduced into the silo, detected by means of an anemometer and regulated through a rheostat directly connected to the blower/compressor, is based on the principle that friction velocity is inversely proportional to the time required to generate the induced electrostatic charge.

Control of opening and closing of the material loading and discharge valves in the silo ensures monitoring and metering of the material and represents fundamental parameters to guarantee correct operation of station 109. In particular, the flow within the electrode zone must be constantly controlled to minimize turbulence and avoid separation errors. Particle trajectory is influenced by particle acceleration and by turbulence that may be generated within the cylinder, considering that aerodynamic drag forces acting on fine particles are greater than gravitational and electrostatic forces. Any corrections, in addition to throttling of the discharge valve, are achieved through a constant-velocity air flow generated by radial blowers.

Control of silo cleanliness is ensured by constant checking of air-cleaning filters and of idle (no-load) cycles for dust removal. The presence of dust and residues on the particles may decrease or increase electrostatic attraction between the molecules of the various materials, creating a sort of insulating or conductive layer depending on its electrical nature, which could limit or facilitate electron exchange.

Control of electrode voltage makes it possible to monitor such parameter continuously as a function of the separation yield achieved.

The fragments are loaded into the silo from above through a dedicated plastic pipe provided with a solenoid valve which, once loading is completed, is closed so as to prevent leakage of material.

The cylinder is filled to one third of its capacity and, by means of radial blowers, compressed air is introduced up to a velocity of about 15 m/s, with temperature and relative humidity maintained respectively at 303 K and 49%. The introduced air assumes a rotary motion, promoted by the design of the silo walls, and imparts an orbital motion to the fragments during processing.

Particles driven by the air, due to mutual contact-friction and friction against the PET wall, tend to generate and accumulate on their surface an electrical charge depending on the magnitude of their surface potential, which differs for the various material types.

Such process exploits the ability of each material to accumulate electrostatic charges on its surface as a result of friction with another material. This electrification method enables application of electrostatic separation to a wide range of materials, including polyethylene terephthalate (PET), polyvinyl chloride (PVC), high-density polyethylene (PE-HD), paper, fiberglass, glass, and certain metals. The air used in the work cycle is continuously cleaned and recycled through the use of dedicated filters.

After one minute of mixing within the cyclonic blower, the discharge valve is opened and the particles fall by gravity into the area between the electrodes. Under the influence of the electrostatic charge acquired in the gravitational silo, the particles are separated by the electric field generated by the electrodes. Being able to continuously modulate electrode potential makes it possible to calculate the electrostatic deflection of the individual materials and to subdivide their collection into dedicated containers.

The present invention also relates to a process for recovering electronic components and raw materials from PCB boards.

In detail, said process for recovering electronic components and raw materials from PCB boards comprises the steps of:
- automatic loading and cataloguing of at least one PCB board onto a conveyor belt by means of a multidimensional analyser consisting of a tunnel provided with a barcode and QR code reader for codes applied on said at least one PCB board;
- storing said PCB boards, each in a corresponding rack module 102a;
- disassembling electronic components from the PCB boards;
- analysing and separating the electronic components disassembled from the PCB boards, comprising the steps of identifying and separating disassembled electronic components assessed as reusable;
- cleaning and packaging said reusable disassembled electronic components;
- granulation of both the PCB boards deprived of all the disassembled electronic components and of the disassembled electronic components assessed as not reusable;
- pulverizing fragments produced in the preceding granulation step by means of an orbital micronizer;
- separating raw materials by means of at least one magnetic separation stage 108a, at least one pulsed magnetic-gradient separation stage, at least one electrostatic separation stage, and at least one eddy-current separation stage; and
- recovering plastic material by electrostatic separation.

Advantageously, according to the invention, the computer program product based on Model Predictive Control (MPC) logic comprises a machine-learning module with an evolutionary mechanism aimed at learning and improving over time the functionalities and the target outcomes to be achieved, capable of collecting data and information coming from the individual operating stations 101, 102, ..., 109, simulating the results achievable in the various processing stages based on available variables, interacting with continuous-control modules to propose any real-time changes, dynamically recognizing working settings by comparing them with centralized data, identifying its own capabilities, and cooperating to control production and support its own reconfiguration.

Advantageously, according to the invention, the first loading and cataloguing station 101 implements a an advanced visual-analysis technique which, through the combined use of a line-scan camera and a reader enabled with PowerGrid decoding algorithms, reads and classifies the boards in a dedicated database.

Advantageously, according to the invention, the first loading and cataloguing station 101 provides a PCB board management system based on enabling factors that homogenize subsequent treatments.

Advantageously, according to the invention, the third disassembly station 103 implements a fully automated PCB board dismantling technique which enables both recovery of stillfunctioning components intended for reuse and increased efficiency, safety and quality in the subsequent processing stages.

Advantageously, according to the invention, the fourth analysis and separation station 104 provides an advanced system for separation, analysis and recovery of functional disassembled electronic components.

Advantageously, according to the invention, the fourth analysis and separation station 104 provides an advanced automatic system for cataloguing and sorting reusable electronic components according to homogeneous characteristics, while also ensuring waste reduction and optimization of the quality of recovered material.

Advantageously, according to the invention, the fifth cleaning station 105 provides an automatic cleaning system for reusable electronic components that can be reintroduced into a secondary production cycle.

Advantageously, according to the invention, the fifth cleaning station 105 provides an advanced automatic packaging, or enveloping, system for reusable electronic components.

Advantageously, according to the invention, the sixth granulation station 106 provides an advanced comminution technique through the use of a fully automated granulator, controlled by a PLC in synergy with a microprocessor connected to the central management software, or MES, which continuously monitors operating parameters and adapts them in relation to the set objectives.

Advantageously, according to the invention, the seventh station 107 provides an advanced pulverization technique through the use of an orbital micronizer capable of obtaining an optimal particle size distribution for the subsequent magnetic separation treatment.

Advantageously, according to the invention, the eighth separation station 108 represents an automated stage which, exploiting the responsiveness of materials to magnetic stresses, is capable of pre-separating the largest fraction of mixed metals and non-metals, enabling an efficient process chain.

Advantageously, according to the invention, the eighth separation station 108 represents an environmentally compatible solution for the recovery and reuse of the metallic and non-metallic fractions of PCBs to be reintroduced into the market.

Advantageously, according to the invention, the eighth separation station 108 ensures fine analysis of the material obtained from the upstream pulverization stage, thereby providing data on particle size as well as on shape and material composition, with the aim of homogenizing fragments according to their composition, thus making downstream processing stages more efficient and targeted.

Advantageously, according to the invention, the ninth station 109 enables efficient separation of plastic, ceramic and glass materials to be used in the plastics industry, ceramics industry and/or brick-making industry.

Therefore, the automated platform for recovering electronic components and raw materials from PCB boards according to the invention implements technological processes intended to simplify, optimize and render economically sustainable the recycling of PCB boards, in full respect of the environment and within a "zero-waste" perspective, maximizing recovery of critical raw materials and minimizing environmental impact.

Furthermore, the automated platform and the related process for recovering electronic components and raw materials from PCB boards introduce integrated technologies and enabling factors in the dismantling, shredding, micronization, separation and recycling stages of the materials present on PCB boards.

A further advantage of the automated platform for recovering electronic components and raw materials from PCB boards according to the invention is that its use is readily applicable, convenient and sustainable.

Finally, the automated platform for recovering electronic components and raw materials from PCB boards and the related process according to the invention are carried out at ambient temperature and by using mechanical/physical methodologies that do not involve chemical products or baths, thereby avoiding the release of fumes into the atmosphere and thus ensuring full environmental compatibility.

It is finally clear that modifications and variants may be made to the automated platform for recovering electronic components and raw materials from PCB boards and to the related process described and illustrated herein, without thereby departing from the scope of protection of the present invention, as defined in the appended claims.

## Claims

1. An automated platform for recovering electronic components and raw materials from PCB boards, comprising:
- a plurality of operating stations (101, 102, ..., 109) comprising at least: a first station (101) for automatic loading and cataloguing of at least one PCB board onto a conveyor belt; a second station (102) for storing said at least one PCB board in at least one rack module (102a); a third station (103) for disassembling electronic components from said at least one PCB board; a fourth station (104) for analysing and separating the electronic components disassembled from said at least one PCB board, configured to identify and separate reusable disassembled electronic components from non-reusable disassembled electronic components; a fifth station (105) for cleaning said reusable disassembled electronic components; a sixth station (106) for granulation adapted to comminute said at least one PCB board, stripped of the disassembled electronic components, and the non-reusable disassembled electronic components; a seventh station (107) for pulverizing fragments produced by the sixth station (106); an eighth station (108) for separation of raw materials; and a ninth station (109) configured for recovering plastic material; and
- a computer program product configured to manage said plurality of operating stations (101, 102, ..., 109).

2. The automated platform for recovering electronic components and raw materials from PCB boards according to claim 1, wherein each operating station included in said plurality of operating stations (101, 102, ..., 109) comprises at least one corresponding electronic control unit included in a plurality of electronic control units.

3. The automated platform for recovering electronic components and raw materials from PCB boards according to claim 1, wherein the first loading and cataloguing station (101) comprises a multidimensional analyser consisting of a tunnel provided with an LED lighting system and a barcode and QR code reader for codes applied on said at least one PCB board.

4. The automated platform for recovering electronic components and raw materials from PCB boards according to claim 1, wherein the second storage station (102) comprises at least one mechanical arm and a plurality of pressure and positioning sensors configured to assist insertion of said at least one PCB board into a slot comprised in a corresponding rack module (102a).

5. The automated platform for recovering electronic components and raw materials from PCB boards according to claim 1, wherein the third disassembly station (103) comprises:
- at least one camera configured to detect QR codes or RFID tags applied on said at least one rack module (102a);
- a tunnel comprising a dual-rail carriage configured to handle said at least one rack module (102a) and to perform preheating of said at least one PCB board;
- a preheating module for said at least one PCB board within said tunnel; and
- a sealed working chamber housing said at least one PCB board and configured to disassemble said at least one PCB board by means of diffusion of a vapor generated by boiling a heat-transfer fluid.

6. The automated platform for recovering electronic components and raw materials from PCB boards according to claim 1, wherein the fourth analysis and separation station (104) comprises:
- an analysis system provided with a multidimensional optical analyser configured to verify, by means of Deep Learning Vision logic, the mechanical and electrical functionality of at least one electronic component disassembled from said at least one PCB board; and
- an automated separation system for reusable disassembled electronic components, comprising self-moving blowing nozzles.

7. The automated platform for recovering electronic components and raw materials from PCB boards according to claim 1, wherein the fifth cleaning station (105) comprises: an ultrasonic cleaning block; and a robotic module (105b) configured to package reusable disassembled electronic components and to place said reusable disassembled electronic components into a plurality of compartments (105a).

8. The automated platform for recovering electronic components and raw materials from PCB boards according to claim 1, wherein the sixth granulation station (106) comprises: a granulator stage comprising rotating blades having variable speed and geometry, coated by means of nanostructures; a sieve (106a) arranged at a lower portion of said sixth station (106); and a vibrating discharge chute for discharging, into a plurality of tanks, the fragments of said at least one PCB board stripped of the disassembled electronic components and said non-reusable disassembled electronic components.

9. The automated platform for recovering electronic components and raw materials from PCB boards according to claim 1, wherein the seventh pulverization station (107) comprises:
- one or more electric motors connected to a centrifugal compressor;
- an orbital micronizer, of cylindrical shape, comprising at least two superposed chambers in which the fragments of said at least one PCB board stripped of the disassembled electronic components and of said non-reusable disassembled electronic components are subjected to a circular flow of air or nitrogen;
- a hopper provided with a hermetically sealed pneumatic valve, configured to feed said fragments into said orbital micronizer; and
- a set of nozzles configured to generate air flows having differentiated velocities and pressures, adapted to cause said fragments to collide with one another and with the walls of said orbital micronizer; and wherein the seventh pulverization station (107) further comprises a primary cyclone, a secondary cyclone, and a dynamic classifier configured to carry out separation of said fragments.

10. The automated platform for recovering electronic components and raw materials from PCB boards according to claim 1, wherein the eighth raw-material separation station (108) comprises:
- at least one magnetic separation stage (108a) comprising a drum provided with movable magnets;
- at least one pulsed magnetic-gradient separation stage;
- at least one electrostatic separation stage comprising a tungsten-wire electrode; and
- at least one eddy-current separation stage comprising a rotating drum and a spectroscopic selection module provided with LIBS (Laser-Induced Breakdown Spectroscopy) sensors.

11. The automated platform for recovering electronic components and raw materials from PCB boards according to claim 1, wherein the ninth plastic-material recovery station (109) comprises:
- an electrostatic separation stage;
- a Raman spectrograph;
- a metal cylinder provided with a solenoid valve and inner walls lined with PET;
- a cyclonic blower; and
- a separation unit consisting of a cylinder made of insulating material and provided with two high-voltage copper electrodes.

12. The automated platform for recovering electronic components and raw materials from PCB boards according to claim 2, wherein said computer program product is based on a distributed architecture comprising MPC (Model Predictive Control) control logic, and comprises:
- an MES (Manufacturing Execution System) control software module, comprising an upper software layer for control of said automated platform and a lower software layer for control of each electronic control unit included in said plurality of electronic control units;
- a communication software module configured to manage data transmission between each electronic control unit of the corresponding operating station and said MES control software module;
- a software module for performance management of operating stations (101, 102, ..., 109);
- a software module based on machine-learning logic configured to enable learning by said MES control software module;
- an analysis and classification software module, based on deep-learning vision logic, configured to evaluate the appearance of the electronic components disassembled from said at least one PCB board by means of the fourth station (104); and
- a disassembly-simulation software module configured to evaluate achievable results in terms of quality, quantity and value and to transmit said results to said MES control software module.

13. The automated platform for recovering electronic components and raw materials from PCB boards according to claim 12, wherein each electronic control unit is connected to the MES control software module.

14. The automated platform for recovering electronic components and raw materials from PCB boards according to claim 2, wherein each electronic control unit is implemented by a PLC, a microcontroller, or a microprocessor.

15. A process for recovering electronic components and raw materials from PCB boards by means of the automated platform according to any one of the preceding claims, comprising the steps of:
- automatically loading and cataloguing at least one PCB board by means of a multidimensional analyser;
- storing said at least one PCB board in at least one rack module (102a);
- disassembling electronic components from said at least one PCB board;
- analysing and separating the electronic components disassembled from said at least one PCB board, comprising identifying and separating disassembled electronic components assessed as reusable;
- cleaning and packaging said reusable disassembled electronic components;
- granulation of said at least one PCB board stripped of the disassembled electronic components and of the disassembled electronic components assessed as not reusable;
- pulverizing fragments produced in the preceding granulation step by means of an orbital micronizer;
- separating raw materials by means of at least one magnetic separation stage (108a), at least one pulsed magnetic-gradient separation stage, at least one electrostatic separation stage, and at least one eddy-current separation stage; and
- recovering plastic material by electrostatic separation.
